# EUROPEAN PATENT APPLICATION

(11) **EP 4 167 269 A1**
(43) Date of publication of application: **19.04.2023**
(21) Application number: 21202841.9
(22) Date of filing: 15.10.2021
(51) Int. Cl.: H01L 21/02, H01L 27/146

(54) **HETEROEPITAXIAL SEMICONDUCTOR DEVICE AND METHOD FOR FABRICATING A HETEROEPITAXIAL SEMICONDUCTOR DEVICE**

(71) Applicant: Infineon Technologies AG, 85579 Neubiberg (DE)
(72) Inventor: PARASCANDOLA, Stefano, 01109 Dresden (DE); MONO, Tobias, 01099 Dresden (DE); OFFENBERG, Dirk, 01099 Dresden (DE)
(74) Representative: Lambsdorff & Lange Patentanwälte Partnerschaft mbB

(57) **Abstract**

A heteroepitaxial semiconductor device comprises a seed layer comprising a first semiconductor material, the seed layer comprising a first side, an opposing second side and lateral sides connecting the first and second sides, a separation layer arranged at the first side of the seed layer, the separation layer comprising an aperture, a heteroepitaxial structure grown at the first side of the seed layer at least in the aperture and comprising a second semiconductor material, different from the first semiconductor material, and a first dielectric material layer arranged at the second side of the seed layer and covering the lateral sides of the seed layer.

## Description

### TECHNICAL FIELD

This disclosure relates in general to a heteroepitaxial semiconductor device as well as to a method for fabricating such a heteroepitaxial semiconductor device.

### BACKGROUND

A heteroepitaxial semiconductor device may for example comprise a layer, i.e. a seed layer, of a first semiconductor material and a structure heteroepitaxially grown on the seed layer, wherein the structure comprises a second, different semiconductor material. Such heteroepitaxial semiconductor devices may for example be part of an image sensor, in particular part of a pixel of an image sensor. The first semiconductor material may e.g. be Si and the second semiconductor material may e.g. be Ge. A particular type of such image sensors is configured for backside illumination (BSI) due to superior optical properties of this technology. It may be desirable to use heteroepitaxial structures with as few crystal defects as possible because otherwise the sensor quality would be negatively affected. Such crystal defects may be caused by dislocations which originate from the boundary between the seed layer and the heteroepitaxial structure. Improved heteroepitaxial semiconductor devices and improved methods for fabricating such devices may help with solving these and other problems.

The problem on which the invention is based is solved by the features of the independent claims. Further advantageous examples are described in the dependent claims.

### SUMMARY

Various aspects pertain to a heteroepitaxial semiconductor device, comprising: a seed layer comprising a first semiconductor material, the seed layer comprising a first side, an opposing second side and lateral sides connecting the first and second sides, a separation layer arranged at the first side of the seed layer, the separation layer comprising an aperture, a heteroepitaxial structure grown at the first side of the seed layer at least in the aperture and comprising a second semiconductor material, different from the first semiconductor material, and a first dielectric material layer arranged at the second side of the seed layer and covering the lateral sides of the seed layer.

Various aspects pertain to a method for fabricating a heteroepitaxial semiconductor device for backside illumination, the method comprising: providing a structure which comprises a substrate, a separation layer on the substrate, and a seed layer on the separation layer, the seed layer comprising a first semiconductor material, and the seed layer comprising a first side, an opposing second side and lateral sides connecting the first and second sides, wherein the first side of the seed layer faces the separation layer, fabricating a first dielectric material layer at the second side of the seed layer and thereby covering the lateral sides of the seed layer with the first dielectric material layer, removing the substrate, generating an aperture in the separation layer, and growing a heteroepitaxial structure on the first side of the seed layer in the aperture, wherein the heteroepitaxial structure comprises a second semiconductor material, different from the first semiconductor material.

### BRIEF DESCRIPTION OF THE DRAWINGS

The accompanying drawings illustrate examples and together with the description serve to explain principles of the disclosure. Other examples and many of the intended advantages of the disclosure will be readily appreciated in view of the following detailed description. The elements of the drawings are not necessarily to scale relative to each other. Identical reference numerals designate corresponding similar parts.
Figure 1 shows a sectional view of a heteroepitaxial semiconductor device.
Figure 2 shows a detail view of part of the heteroepitaxial semiconductor device of Fig. 1.
Figure 3 shows a sectional view of a further heteroepitaxial semiconductor device comprising diode structures and modulation gate structures.
Figure 4 shows a sectional view of a further heteroepitaxial semiconductor device, wherein direct bonding or hybrid bonding was used to bond a second substrate to other parts of the heteroepitaxial semiconductor device.
Figure 5 shows a sectional view of a further heteroepitaxial semiconductor device comprising a microlens and through silicon vias.
Figures 6A to 6H show a heteroepitaxial semiconductor device in various stages of fabrication according to an exemplary method of fabrication.
Figure 7 is a flow chart of an exemplary method for fabricating heteroepitaxial semiconductor devices.

### DETAILED DESCRIPTION

In the following detailed description, directional terminology, such as "top", "bottom", "left", "right", "upper", "lower" etc., is used with reference to the orientation of the Figure(s) being described. Because components of the disclosure can be positioned in a number of different orientations, the directional terminology is used for purposes of illustration only. It is to be understood that other examples may be utilized and structural or logical changes may be made.

In addition, while a particular feature or aspect of an example may be disclosed with respect to only one of several implementations, such feature or aspect may be combined with one or more other features or aspects of the other implementations as may be desired and advantageous for any given or particular application, unless specifically noted otherwise or unless technically restricted. The terms "coupled" and "connected", along with derivatives thereof may be used. It should be understood that these terms may be used to indicate that two elements cooperate or interact with each other regardless whether they are in direct physical or electrical contact, or they are not in direct contact with each other; intervening elements or layers may be provided between the "bonded", "coupled", or "connected" elements. However, it is also possible that the "bonded", "coupled", or "connected" elements are in direct contact with each other. Also, the term "exemplary" is merely meant as an example, rather than the best or optimal.

In several examples layers or layer stacks are applied to one another or materials are applied or deposited onto layers. It should be appreciated that any such terms as "applied" or "deposited" are meant to cover literally all kinds and techniques of applying layers onto each other. In particular, they are meant to cover techniques in which layers are applied at once as a whole as well as techniques in which layers are deposited in a sequential manner.

An efficient heteroepitaxial semiconductor device may for example reduce material consumption, ohmic losses, chemical waste, etc. and thus enable energy and/or resource savings. Improved heteroepitaxial semiconductor devices and improved methods for fabricating heteroepitaxial semiconductor devices, as specified in this description, may thus at least indirectly contribute to green technology solutions, i.e. climate-friendly solutions providing a mitigation of energy and/or resource use.

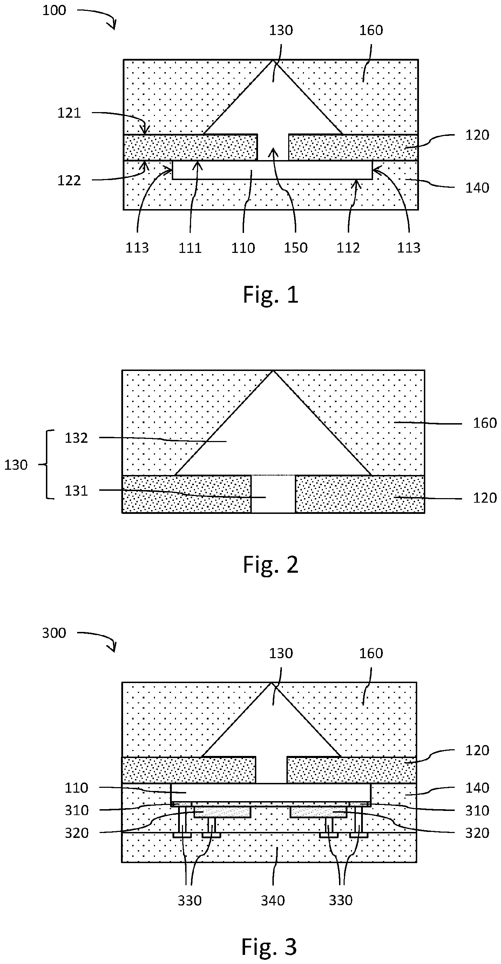

Figure 1 shows a heteroepitaxial semiconductor device 100 comprising a seed layer 110, a separation layer 120, a heteroepitaxial structure 130, and a first dielectric material layer 140.

The heteroepitaxial semiconductor device 100 may for example be part of an image sensor, for example a time of flight image sensor. The heteroepitaxial semiconductor device 100 may in particular be part of a pixel of the image sensor and the heteroepitaxial structure 130 may constitute a photosensitive part of the pixel.

According to an example, the heteroepitaxial semiconductor device 100 is configured for backside illumination (BSI), wherein the photosensitive part (i.e. the heteroepitaxial structure 130) on the one hand and metallization structures, modulation gates, diodes, etc. on the other hand are arranged relative to each other such that photons to be detected do not need to pass the metallization structures, modulation gates, diodes etc. before being absorbed in the photosensitive part.

The seed layer 110 comprises or consists of a first semiconductor material. The seed layer 110 may be a crystalline seed layer. The seed layer 110 may for example be a "silicon on insulator" (SOI) structure. The first semiconductor material may for example be Si. The seed layer 110 comprises a first side 111, an opposing second side 112 and lateral sides 113 connecting the first and second sides 111, 112.

The seed layer 110 may have any suitable dimensions. For example, the seed layer 110 may have a thickness measured between the first and second sides 111, 112 of 1µm or less, or 500nm or less, or 100nm or less, or 50nm or less, or 20nm or less, or 10nm or less. The seed layer 110 may e.g. have a lateral extension measured between opposing lateral sides 113 of 100µm or less, or 50µm or less, or 10µm or less, or 5µm or less.

The separation layer 120 is arranged at the first side 111 of the seed layer 110. The separation layer 120 may have dielectric properties. The separation layer 120 may for example comprise or consist of a (buried) oxide layer. The separation layer 120 may for example comprise or consist of silicon oxide.

The separation layer 120 may comprise a first side 121 and an opposing second side 122, wherein the first side 121 faces away from the seed layer 110. The second side 122 of the separation layer 120 may be in direct contact with the first side 111 of the seed layer 110. The second side 122 of the separation layer 120 may be in direct contact with the first dielectric material layer 140.

The separation layer 120 comprises an aperture 150. The aperture 150 may extend from the first side 121 to the second side 122 of the separation layer 120. The aperture 150 may be filled, in particular completely filled, by the heteroepitaxial structure 130.

The separation layer 120 may have any suitable thickness, for example a thickness of 1µm or less, or 500nm or less, or 100nm or less, or 50nm or less.

The heteroepitaxial structure 130 is grown at the first side 111 of the seed layer 110, at least in the aperture 150. The heteroepitaxial structure 130 may be in direct contact with the first side 111 of the seed layer 110. The heteroepitaxial structure 130 comprises a second semiconductor material which may be different from the first semiconductor material of the seed layer 110. The first and second semiconductor materials may be any suitable semiconductor materials. The first and second semiconductor materials may have similar lattice constants and/or similar thermal expansion coefficients. According to an example, the first semiconductor material is Si and the second semiconductor material is Ge.

The heteroepitaxial structure 130 may have any suitable shape and any suitable dimensions. According to an example, the particular shape of the heteroepitaxial structure 130 is a product of self-organization during epitaxial growth. According to an example, methods like aspect ratio trapping (ART) may be used to grow an essentially defect free heteroepitaxial structure 130 of a particular shape.

As shown in Fig. 1, a lateral extension of the seed layer 110 may be larger than a maximum lateral extension of the heteroepitaxial structure 130. However, it is also possible that the lateral extension of the seed layer 110 is smaller than the maximum lateral extension of the heteroepitaxial structure 130. It is also possible that the seed layer 110 has a rectangular shape such that along its longer side it is larger than the heteroepitaxial structure 130 but along its shorter side it is smaller than the heteroepitaxial structure 130.

As shown in Fig. 1, the lateral sides 113 of the seed layer 110 may be recessed from lateral sides of the heteroepitaxial semiconductor device 100. Minimizing the lateral dimensions of the seed layer 110 in this manner may help with reducing stress and/or dislocations and defects in the heteroepitaxial structure 130. For this reason, a larger heteroepitaxial structure 130 and/or a heteroepitaxial structure 130 with less dislocations and crystal defects may be grown on the seed layer 110 compared to a seed layer with larger lateral dimensions.

The first dielectric material layer 140 is arranged at the second side 112 of the seed layer 110. The first dielectric material layer 140 may be in direct contact with the second side 112 of the seed layer 110 or there may be one or more intermediate layers arranged between the second side 112 of the seed layer 110 and the first dielectric material layer 140. The first dielectric material layer 140 covers the lateral sides 113 of the seed layer 110. In particular, all lateral sides 113 may be covered by the first dielectric material layer 140. Furthermore, the lateral sides 113 may be in direct contact with the first dielectric material layer 140.

According to an example, the first dielectric material layer 140 comprises or consists of an oxide layer. The oxide layer may e.g. comprise or consist of an oxide of the first semiconductor material of the seed layer 110. The oxide layer may for example comprise a silicon oxide.

According to an example, the heteroepitaxial semiconductor device 100 comprises a second dielectric material layer 160 arranged at the first side 121 of the separation layer 120. The second dielectric material layer 160 may in particular be in direct contact with the first side 121 of the separation layer 120. The second dielectric material layer 160 may be in direct contact with the heteroepitaxial structure 130. In particular, the second dielectric material layer 160 may partially or completely encapsulate the heteroepitaxial structure 130.

The second dielectric material layer 160 may for example comprise or consist of the same dielectric material as the first dielectric material layer 140. According to another example, the first and second dielectric material layers 140, 160 comprise or consist of different dielectric materials. The second dielectric material layer 160 may for example comprise or consist of a silicon oxide.

Figure 2 shows a detail view of the separation layer 120, the heteroepitaxial structure 130 and the second dielectric material layer 160, according to an example.

The heteroepitaxial structure 130 may comprise a trunk portion 131 and a top portion 132 arranged on top of the trunk portion 131. Both the trunk portion 131 and the top portion 132 may be part of a contiguous single piece heteroepitaxial structure 130 and may only be distinguished by their different shapes. The trunk portion 131 may be grown directly on the first side 111 of the seed layer 110 (see Fig. 1).

The trunk portion 131 of the heteroepitaxial structure 130 may be arranged in the aperture 150 in the separation layer 120 and the top portion 132 of the heteroepitaxial structure 130 may be arranged in the second dielectric material layer 160, on top of the separation layer 120. The trunk portion 131 may in particular completely fill the aperture 150.

The separation layer 120 with the aperture 150 may be fabricated on the seed layer 110 prior to growing the heteroepitaxial structure 130. The aperture 150 may in particular be used for aspect ratio trapping (ART). The heteroepitaxial structure 130 may be grown on the seed layer 110 starting in the aperture 150. In this way, dislocations in the heteroepitaxial structure 130 are trapped in the aperture 150 due to the propagation of the dislocations diagonally to the direction of growth of the heteroepitaxial structure 130. The heteroepitaxial structure 130, in particular the top portion 132, may therefore be essentially free of crystal dislocations.

In order to trap said dislocations, the trunk portion 131 (or rather the aperture 150) may have a high aspect ratio. For example, the trunk portion 131 may have an aspect ratio in the range of 100:1 to 1:100, in particular in the range of 1:1 to 1:10, for example about 1:2, or 1:4, or 1:6, or 1:8. It is however also possible that a lower aspect ratio is used, for example 2:1, 3:1, 10:1, 30:1, or even 100:1.

The cross section of the trunk portion 131 as shown in Fig. 2 may essentially have a rectangular shape. In a view perpendicular to the one shown in Fig. 2, onto the plane comprising the second side 122 of the separation layer 120, the trunk portion 131 may for example have a circular shape, a quadratic shape or a rectangular shape.

Aspect ratio trapping, as it may be used for fabricating the heteroepitaxial structure 130, refers to techniques of stopping defects with non-crystalline sidewalls of sufficient height relative to the size of the crystalline growth area. Instead of aspect ratio trapping or in addition to it, the approach for fabricating e.g. the heteroepitaxial semiconductor device 100 may comprise reducing the dislocation density of a lattice mismatched heteroepitaxially grown material by lattice adaption between the seed layer 110 and the epitaxially grown material (i.e. the heteroepitaxial structure 130), in particular by allowing more lattice adaption in the seed layer 110.

The trunk portion 131 of the heteroepitaxial structure 130 may for example have a lateral extension (i.e. a width of the aperture 150) of 1µm or less, or 500nm or less, or 200nm or less, or 100nm or less, or 50nm or less.

The top portion 132 of the heteroepitaxial structure 130 may for example have a cone shape or pyramid shape as shown in Fig. 2. However, the top portion 132 may for example also have a rectangular shape, an inverse cone shape, etc. According to an example, an upper surface of the top portion 132 is exposed from the second dielectric material layer 160, e.g. by use of a chemical mechanical polishing (CMP) process. According to another example, the upper surface of the top portion 132 is covered by the second dielectric material layer 160.

A maximum lateral extension of the top portion 132 may for example be 10µm or less, or 5µm or less, or 2µm or less, or 1µm or less. The top portion 132 may have a height (which may be equal to a thickness of the second dielectric material layer 160) of for example 2µm or less, or 1µm or less, or 500nm or less, or 200nm or less.

Figure 3 shows a further heteroepitaxial semiconductor device 300 which may be similar or identical to the heteroepitaxial semiconductor device 100.

The heteroepitaxial semiconductor device 300 may comprise all parts discussed with respect to Figs. 1 and 2 and it may additionally comprise diodes 310, modulation gates 320, and contacts 330. Additionally, the heteroepitaxial semiconductor device 300 may comprise a third dielectric material layer 340.

The diodes 310 and/or the modulation gates 320 may for example be arranged at the second side 112 of the seed layer 110. In other words, the heteroepitaxial structure 130 on the one hand and the diodes 310 and/or modulation gates 320 on the other hand may be arranged at opposite sides of the seed layer 110.

The contacts 330 may comprise or consist of a suitable metal or metal alloy, e.g. Al, Cu or Fe. The contacts 330 may e.g. be configured to electrically couple the diodes 310 and/or the modulation gates 320 to other components.

The third dielectric material layer 340 may for example be arranged below the first dielectric material layer 140. The third dielectric material layer 340 may comprise or consist of the same dielectric material or of a different dielectric material compared to the first dielectric material layer 140. At least some of the contacts 330 may at least partially extend into the third dielectric material layer 340.

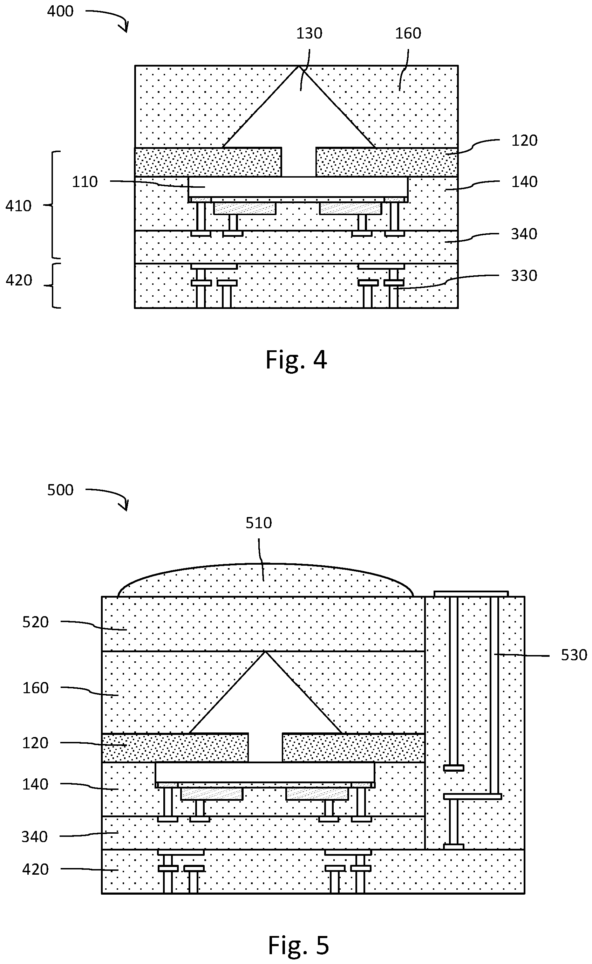

Figure 4 shows a further heteroepitaxial semiconductor device 400 which may be similar or identical to the heteroepitaxial semiconductor device 300, except for the differences described in the following.

In particular, the seed layer 110, the separation layer 120 and the first dielectric material layer 140 (and optionally further components, e.g. the third dielectric material layer 340) may form a first substrate 410 and the heteroepitaxial semiconductor device 400 may additionally comprise a second substrate 420. The second substrate 420 is arranged below the first substrate 410. The second substrate 420 may e.g. comprise or consist of a semiconductor material, e.g. of the first semiconductor material.

The second substrate 420 may comprise a plurality of contacts 330 which may be electrically coupled to one or more components of the first substrate 410, for example to contacts 330 of the first substrate 410.

A wafer level bonding process may have been used to couple the first and second substrates 410, 420 to each other. According to an example, the first and second substrates 410, 420 are coupled by direct bonding. According to another example, the first and second substrates 410, 420 are coupled by hybrid bonding.

Figure 5 shows a further heteroepitaxial semiconductor device 500 which may be similar or identical to the heteroepitaxial semiconductor device 400, except that the heteroepitaxial semiconductor device 500 may comprise additional components described below.

According to an example, the heteroepitaxial semiconductor device 500 comprises a microlens 510 arranged above the heteroepitaxial structure 130. The microlens 510 may comprise or consist of any suitable optically transparent material, e.g. a dielectric material like an oxide. The microlens 510 may be configured to focus photons onto the heteroepitaxial structure 130.

The heteroepitaxial semiconductor device 500 may for example comprise a fourth dielectric material layer 520 arranged over the second dielectric material layer 160 and the heteroepitaxial structure 130. The fourth dielectric material layer 520 may comprise the same material or material composition as the first dielectric material layer 140 or a different material or material composition. The fourth dielectric material layer 520 may be arranged between the microlens 510 and the second dielectric material layer 160 and/or the heteroepitaxial structure 130.

The heteroepitaxial semiconductor device 500 may optionally comprise one or more through silicon vias (TSVs) 530 arranged laterally next to the heteroepitaxial structure 130 and the seed layer 110. The through silicon via(s) 530 may for example be configured to provide an electrical connection with the second substrate 420.

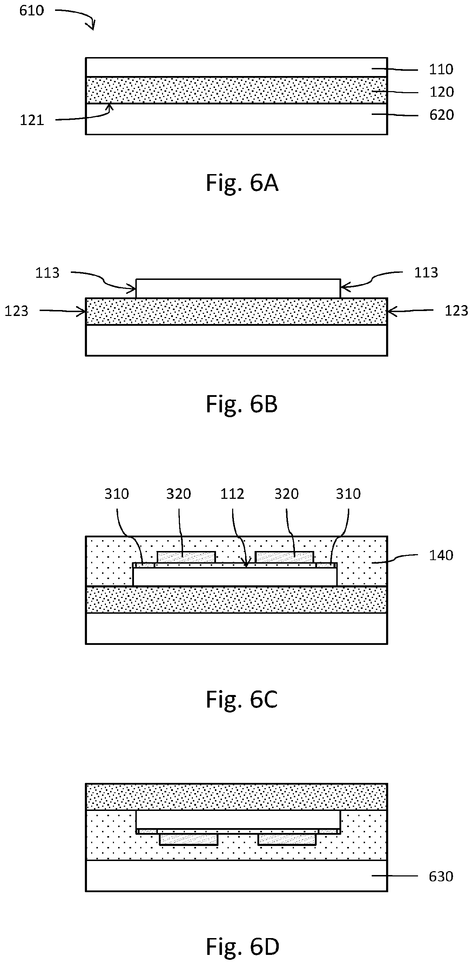

With reference to Figures 6A to 6H a heteroepitaxial semiconductor device 600 is shown in various stages of fabrication, according to an exemplary method for fabricating heteroepitaxial semiconductor devices. A similar method may be used for fabricating the heteroepitaxial semiconductor devices 100 to 500.

As shown in Figure 6A, a structure 610 is provided. The structure 610 comprises the seed layer 110 and the separation layer 120 arranged on a first temporary substrate 620, for example such that the first side 121 of the separation layer 120 faces the first temporary substrate 620. The first temporary substrate 620 may e.g. comprise or consist of Si. The first temporary substrate 620 may e.g. be a semiconductor wafer.

As shown in Figure 6B, a patterning process is applied to the seed layer 110 in order to limit the lateral extension of the seed layer 110, thereby creating the lateral sides 113. The lateral sides 113 of the seed layer 110 may in particular be offset inwards compared to lateral sides 123 of the separation layer 120.

As shown in Figure 6C, the diodes 310 and modulation gates 320 may be fabricated at the second side 112 of the seed layer 110. Fabricating the diodes 310 and the modulation gates 320 may comprise a front end of line (FEOL) process.

Furthermore, the first dielectric material layer 140 may be fabricated, thereby covering the lateral sides 113 of the seed layer 110. According to an example, the lateral sides 123 of the separation layer 120 on the other hand are not covered by the first dielectric material layer 140.

As shown in Figure 6D, a second temporary substrate 630 may be arranged over the first dielectric material layer 140 and the first temporary substrate 620 may be removed. Removing the first temporary substrate 620 may for example comprise an etching process or a grinding process. The second temporary substrate 630 may e.g. be a temporary carrier like a tape.

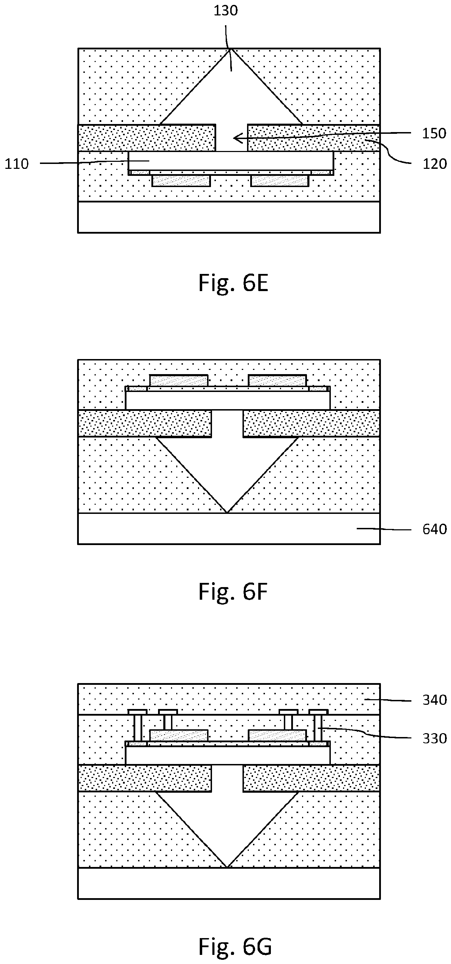

As shown in Figure 6E, the aperture 150 may be fabricated in the separation layer 120. Fabricating the aperture 150 may for example comprise an etching process or a laser drilling process. Subsequently, the heteroepitaxial structure 130 may be grown on the seed layer 110, starting in the aperture 150. Furthermore, the second dielectric material layer 160 may be fabricated. This may in particular be done after the heteroepitaxial structure 130 has been formed.

As shown in Figure 6F, a third temporary substrate 640 may be arranged on the second dielectric material layer 160 and the second temporary substrate 630 may be removed. The third temporary substrate 640 may e.g. be a temporary carrier like a tape.

As shown in Figure 6G, the contacts 330 and optionally the third dielectric material layer 340 are fabricated. This may for example comprise a middle of line (MOL) process and/or a back end of line (BEOL) process.

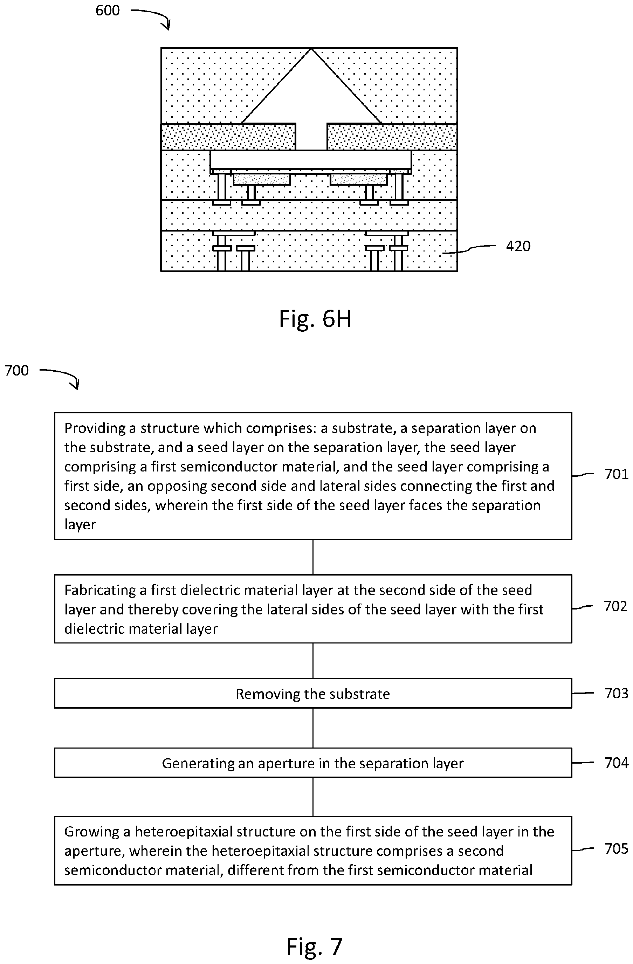

As shown in Figure 6H, the second substrate 420 is provided and may e.g. be coupled to the third dielectric material layer 340. This may e.g. comprise direct bonding or hybrid bonding. The third temporary substrate 640 may be removed.

According to an example, fabricating the heteroepitaxial semiconductor device 600 additionally comprises fabricating the microlens 510, the fourth dielectric material layer 520 and/or the through silicon vias 530 as described with respect to Fig. 5.

Figure 7 is a flow chart of a method 700 for fabricating a heteroepitaxial semiconductor device. The method 700 may for example be used to fabricate the heteroepitaxial semiconductor devices 100 to 600.

The method 700 comprises at 701 an act of providing a structure which comprises: a substrate, a separation layer on the substrate, and a seed layer on the separation layer, the seed layer comprising a first semiconductor material, and the seed layer comprising a first side, an opposing second side and lateral sides connecting the first and second sides, wherein the first side of the seed layer faces the separation layer, at 702 an act of fabricating a first dielectric material layer at the second side of the seed layer and thereby covering the lateral sides of the seed layer with the first dielectric material layer, at 703 an act of removing the substrate, at 704 an act of generating an aperture in the separation layer, and at 705 an act of growing a heteroepitaxial structure on the first side of the seed layer in the aperture, wherein the heteroepitaxial structure comprises a second semiconductor material, different from the first semiconductor material.

### EXAMPLES

In the following, the heteroepitaxial semiconductor device and the method for fabricating a heteroepitaxial semiconductor device are further explained using specific examples.

Example 1 is a heteroepitaxial semiconductor device, comprising: a seed layer comprising a first semiconductor material, the seed layer comprising a first side, an opposing second side and lateral sides connecting the first and second sides, a separation layer arranged at the first side of the seed layer, the separation layer comprising an aperture, a heteroepitaxial structure grown at the first side of the seed layer at least in the aperture and comprising a second semiconductor material, different from the first semiconductor material, and a first dielectric material layer arranged at the second side of the seed layer and covering the lateral sides of the seed layer.

Example 2 is the heteroepitaxial semiconductor device of example 1, wherein the heteroepitaxial structure comprises a trunk portion arranged within the aperture and a top portion arranged on top of the trunk portion and the separation layer, wherein a lateral extension of the trunk portion is smaller than a lateral extension of the top portion, the lateral extensions being measured parallel to the first side of the seed layer.

Example 3 is the heteroepitaxial semiconductor device of example 2, wherein the top portion has an essentially pyramidal shape.

Example 4 is the heteroepitaxial semiconductor device of one of examples 2 or 3, wherein the trunk portion has an aspect ratio in the range of 100:1 to 1:100, in particular in the range of 1:1 to 1:10.

Example 5 is the heteroepitaxial semiconductor device of one of the preceding examples, wherein the seed layer has lateral dimensions measured parallel to the first side of the seed layer of 10µm or less, in particular 5µm or less.

Example 6 is the heteroepitaxial semiconductor device of one of the preceding examples, wherein the first semiconductor material is Si and the second semiconductor material is Ge.

Example 7 is the heteroepitaxial semiconductor device of one of the preceding examples, wherein the separation layer comprises a buried dielectric material layer.

Example 8 is the heteroepitaxial semiconductor device of one of the preceding examples, further comprising: one or more transistor or diode structures arranged at the second side of the seed layer, wherein the one or more transistor or diode structures are arranged within the first dielectric material layer.

Example 9 is the heteroepitaxial semiconductor device of example 8, further comprising: one or more metallic contacts extending at least partially through the first dielectric material layer to the one or more transistor or diode structures.

Example 10 is the heteroepitaxial semiconductor device of one of the preceding examples, further comprising: a second dielectric material layer arranged at the separation layer and at least partially encapsulating the heteroepitaxial structure.

Example 11 is an image sensor, comprising: a heteroepitaxial semiconductor device according to one of the preceding examples, wherein the heteroepitaxial structure forms a photosensitive part of a pixel of the image sensor.

Example 12 is the image sensor of example 11, wherein the image sensor is a time of flight image sensor.

Example 13 is a method for fabricating a heteroepitaxial semiconductor device, the method comprising: providing a structure which comprises a substrate, a separation layer on the substrate, and a seed layer on the separation layer, the seed layer comprising a first semiconductor material, and the seed layer comprising a first side, an opposing second side and lateral sides connecting the first and second sides, wherein the first side of the seed layer faces the separation layer, fabricating a first dielectric material layer at the second side of the seed layer and thereby covering the lateral sides of the seed layer with the first dielectric material layer, removing the substrate, generating an aperture in the separation layer, and growing a heteroepitaxial structure on the first side of the seed layer in the aperture, wherein the heteroepitaxial structure comprises a second semiconductor material, different from the first semiconductor material.

Example 14 is the method of example 13, further comprising: fabricating one or more transistor or diode structures at the second side of the seed layer, and encapsulating the one or more transistor or diode structures with the first dielectric material layer.

Example 15 is the method of example 13 or 14, further comprising: fabricating a second dielectric material layer on the separation layer and at least partially encapsulating the heteroepitaxial structure with the second dielectric material layer.

Example 16 is an apparatus comprising means for performing the method according to one of examples 13 to 15.

While the disclosure has been illustrated and described with respect to one or more implementations, alterations and/or modifications may be made to the illustrated examples without departing from the spirit and scope of the appended claims. In particular regard to the various functions performed by the above described components or structures (assemblies, devices, circuits, systems, etc.), the terms (including a reference to a "means") used to describe such components are intended to correspond, unless otherwise indicated, to any component or structure which performs the specified function of the described component (e.g., that is functionally equivalent), even though not structurally equivalent to the disclosed structure which performs the function in the herein illustrated exemplary implementations of the disclosure.

## Claims

1. A heteroepitaxial semiconductor device (100), comprising:
a seed layer (110) comprising a first semiconductor material, the seed layer (110) comprising a first side (111), an opposing second side (112) and lateral sides (113) connecting the first and second sides (111, 112),
a separation layer (120) arranged at the first side (111) of the seed layer (110), the separation layer (120) comprising an aperture (150),
a heteroepitaxial structure (130) grown at the first side (111) of the seed layer (110) at least in the aperture (150) and comprising a second semiconductor material, different from the first semiconductor material, and
a first dielectric material layer (140) arranged at the second side (112) of the seed layer (110) and covering the lateral sides (113) of the seed layer (110).

2. The heteroepitaxial semiconductor device (100) of claim 1,
wherein the heteroepitaxial structure (130) comprises a trunk portion (131) arranged within the aperture (150) and a top portion (132) arranged on top of the trunk portion (131) and the separation layer (120),
wherein a lateral extension of the trunk portion (131) is smaller than a lateral extension of the top portion (132), the lateral extensions being measured parallel to the first side (111) of the seed layer (110).

3. The heteroepitaxial semiconductor device (100) of claim 2, wherein the top portion (132) has an essentially pyramidal shape.

4. The heteroepitaxial semiconductor device (100) of one of claims 2 or 3, wherein the trunk portion (131) has an aspect ratio in the range of 100:1 to 1:100, in particular in the range of 1:1 to 1:10.

5. The heteroepitaxial semiconductor device (100) of one of the preceding claims, wherein the seed layer (110) has lateral dimensions measured parallel to the first side (111) of the seed layer (110) of 10µm or less, in particular 5µm or less.

6. The heteroepitaxial semiconductor device (100) of one of the preceding claims, wherein the first semiconductor material is Si and the second semiconductor material is Ge.

7. The heteroepitaxial semiconductor device (100) of one of the preceding claims, wherein the separation layer (120) comprises a buried dielectric material layer.

8. The heteroepitaxial semiconductor device (300) of one of the preceding claims, further comprising:
one or more transistor or diode structures (310, 320) arranged at the second side (112) of the seed layer (110),
wherein the one or more transistor or diode structures (310, 320) are arranged within the first dielectric material layer (140).

9. The heteroepitaxial semiconductor device (300) of claim 8, further comprising:
one or more metallic contacts (330) extending at least partially through the first dielectric material layer (140) to the one or more transistor or diode structures (310, 320).

10. The heteroepitaxial semiconductor device (100) of one of the preceding claims, further comprising:
a second dielectric material layer (160) arranged at the separation layer (120) and at least partially encapsulating the heteroepitaxial structure (130).

11. An image sensor, comprising:
a heteroepitaxial semiconductor device (100, 300, 400, 500, 600) according to one of the preceding claims,
wherein the heteroepitaxial structure (130) forms a photosensitive part of a pixel of the image sensor.

12. The image sensor of claim 11, wherein the image sensor is a time of flight image sensor.

13. A method (700) for fabricating a heteroepitaxial semiconductor device, the method (700) comprising:
providing (701) a structure which comprises:
a substrate,
a separation layer on the substrate, and
a seed layer on the separation layer, the seed layer comprising a first semiconductor material, and the seed layer comprising a first side, an opposing second side and lateral sides connecting the first and second sides, wherein the first side of the seed layer faces the separation layer,
fabricating (702) a first dielectric material layer at the second side of the seed layer and thereby covering the lateral sides of the seed layer with the first dielectric material layer,
removing (703) the substrate,
generating (704) an aperture in the separation layer, and
growing (705) a heteroepitaxial structure on the first side of the seed layer in the aperture, wherein the heteroepitaxial structure comprises a second semiconductor material, different from the first semiconductor material.

14. The method (700) of claim 13, further comprising:
fabricating one or more transistor or diode structures at the second side of the seed layer, and
encapsulating the one or more transistor or diode structures with the first dielectric material layer.

15. The method (700) of claim 13 or 14, further comprising:
fabricating a second dielectric material layer on the separation layer and at least partially encapsulating the heteroepitaxial structure with the second dielectric material layer.
